# EUROPÄISCHE PATENTSCHRIFT

(11) **EP 1 585 234 B1**
(45) Veröffentlichungstag und Bekanntmachung des Hinweises auf die Patenterteilung: **12.10.2011**
(21) Anmeldenummer: 05102194.7
(22) Anmeldetag: 18.03.2005
(51) Int. Cl.: H04B 10/06, H03D 9/06

(54) **Photomischdetektor (PMD)-System und Verfahren zum Betreiben desselben**
Photoelectronic Mixing Device (PMD) system and method for operating a PMD
Système de mélangeur photoélectronique (PMD) et méthode d'opération d'un PMD

(30) Priorität: 05.04.2004 DE 102004016625
(43) Veröffentlichungstag der Anmeldung: 12.10.2005
(73) Patentinhaber: PMDTechnologies GmbH, 57076 Siegen (DE); Audi Electronics Venture GmbH, 85080 Gaimersheim (DE)
(72) Erfinder: Xu, Zhanping, 57250 Netphen (DE); Frey, Jochen, 35578 Wetzlar (DE); Möller, Tobias, 36137 Grossenlüder (DE); Kraft, Holger, 57078 Siegen (DE); Riedel, Helmut, Dr., 86697 Oberhausen (DE)
(74) Vertreter: Weber, Roland

(56) Entgegenhaltungen:
- WO-A-03/073602
- DE-A1- 10 047 170
- DE-A1- 19 704 496
- US-A1- 2004 012 834
- HEINOL H G ET AL: "PHOTOMISCHDETEKTOR ERFASST 3D-BILDER NEUES OPTISCHES BAUELEMENT VEREINIGT DETEKTION UND MISCHUNG" ELEKTRONIK, WEKA FACHZEITSCR.-VERLAG, MUNCHEN, DE, Bd. 48, Nr. 12, 15. Juni 1999 (1999-06-15), Seite 80,82,84,86,88,90, XP000913168 ISSN: 0013-5658

## Beschreibung

Die vorliegende Erfindung betrifft ein elektromagnetisches Mischsystem für den Empfang und die Verarbeitung modulierter elektromagnetischer Strahlungssignale, mit einem Signaldetektor aus einem Halbleitermaterial für den Empfang und die Umwandlung modulierter elektromagnetischer Strahlungssignale in eine elektrische Meßgröße und mit mindestens einem den Empfang des Signaldetektors modulierenden Modulationseingang, sowie mit mindestens zwei Akkumulationselektroden, die mit einer Ausgangselektronik verbunden sind, an deren Ausgang effektiv eine Mischung des empfangenen modulierten elektromagnetischen Strahlungssignals und mindestens eines am Modulationseingang anliegenden Modulationssignals als elektrisches Ausgangssignal bereitgestellt wird.

Desgleichen betrifft die vorliegende Erfindung auch ein Verfahren zum Betreiben eines solchen elektromagnetischen Mischsystems für den Empfang und die Verarbeitung modulierter elektromagnetischer Strahlungssignale, mit einem Signaldetektor aus einem Halbleitermaterial für den Empfang und die Umwandlung modulierter elektromagnetischer Strahlungssignale in eine elektrische Meßgröße, und mit mindestens einem den Empfang des Signaldetektors modulierenden Modulationseingang, sowie mindestens zwei Akkumulationselektroden, die mit einer Ausgangselektronik verbunden sind, an deren Ausgang effektiv eine Mischung des empfangenen modulierten elektromagnetischen Strahlungssignals und mindestens eines am Modulationseingang anliegenden Modulationssignals als elektrisches Ausgangssignal bereitgestellt wird, wobei durch die auf den Signaldetektor auftreffenden modulierten elektromagnetischen Strahlungssignale Ladungsträger erzeugt werden, die nach Maßgabe des mindestens einen Modulationssignals zumindest teilweise abwechselnd auf die beiden verschiedenen Akkumulationselektroden geleitet werden.

Entsprechende elektronische Mischsysteme sind erstmalig in den deutschen Patentanmeldungen Nr. 196 35 932.5 und 197 04 496.4 beschrieben worden.

Weitere elektromagnetische Mischsysteme der vorstehend genannten Art sowie entsprechende Verfahren zu deren Beschreibung sind bekannt aus den internationalen Patentanmeldungen: WO-0233817 und WO-0233922.

Diese elektromagnetischen Mischsysteme werden in den vorgenannten Druckschriften auch als PMD-Systeme (Photomischdetektor-Systeme) bezeichnet. Als nächstliegender Gegenstand für die vorliegende Patentanmeldung wird der Gegenstand der DE 100 47 170 C2 angesehen.

Ein entsprechendes Mischsystem weist zumindest einen Ausgang und zumindest einen Modulationseingang auf. Der Modulationseingang ist mit mindestens einer Modulationselektrode verbunden, die auf einem für elektromagnetische Strahlung empfindlichen (im allgemeinen photoempfindlichen) Material angeordnet bzw. in dieses eingebettet ist. Weiterhin sind der mindestens einen Modulationselektrode auch mindestens zwei Akkumulationselektroden zugeordnet, von denen eine auch mit einer Modulationselektrode identisch sein kann, oder im Falle der Verwendung zweier Modulationselektroden, auch beide Akkumulationselektroden mit den jeweiligen Modulationselektroden identisch sein können. Diese Akkumulationselektroden sind mit einer Auslese- und Auswerteelektronik verbunden. Die von den Akkumulationselektroden abgeleiteten Ladungen bzw. die dort entstehenden Spannungen bilden, gegebenenfalls nach erforderlicher Verstärkung, die Eingangssignale der Ausgangselektronik, wobei in der Regel das Differenzsignal der von den Akkumulationselektroden abgeleiteten Signale ausgewertet wird, welche die Korrelation des mindestens einen Modulationssignals mit der Modulation des elektromagnetischen Eingangssignals bzw. der auftreffenden elektromagnetischen Strahlung wiedergibt.

Bei Verwendung von mehreren (z. B. zwei) Modulationssignalen haben diese die gleiche Frequenz und sind bei den bekannten PMD-Elementen um 180° gegeneinander phasenverschoben, d.h. sie laufen im Gegentakt.

Elektromagnetische Mischsysteme bzw. PMD-Elemente, wie sie im folgenden genannt werden, können je nach Art des Sensors bzw. Sensormaterials auf Strahlung aus dem gesamten elektromagnetischen Spektrum empfindlich sein. Selbst auf Schallwellen empfindliche PMD-Systeme sind prinzipiell denkbar. Im folgenden soll jedoch, zur Vereinfachung der Beschreibung im wesentlichen von PMD-Elementen die Rede sein, die auf Strahlung im optischen Bereich empfindlich sind, ohne daß damit irgendeine Beschränkungsabsicht verbunden ist. Die Verallgemeinerung auf andere Bereiche des elektromagnetischen Spektrums liegt für Fachleute auf der Hand.

Ein photoempfindliches Sensormaterial (Halbleitermaterial), in welches die Elektroden eingebettet bzw. mit welchem sie verbunden sind, empfängt Strahlung, die aufgrund des Photoeffekts in Ladung umgewandelt wird. Aufgrund der an den Modulationselektroden anliegenden Modulationsspannungen werden die in dem Halbleitermaterial erzeugten Ladungsträger je nach dem aktuellen Vorzeichen der Spannung abwechselnd bevorzugt zu dem einen oder anderen Akkumulationselektrode geleitet.

Wenn die Intensität der Strahlung, mit welcher das PMD-Element beaufschlagt wird, gemäß einer Modulationsfunktion variiert, die in kohärenter Beziehung zu der Frequenz der Modulationsspannungen steht, so entspricht das Differenzsignal der Ausleseelektroden der Korrelationsfunktion der einfallenden Strahlungsintensität und der Modulationsspannungen.

Im Falle eines photoempfindlichen Halbleiters verwendet man beispielsweise intensitätsmoduliertes Licht für die Beleuchtung einer Szene, die über eine entsprechende Optik von dem PMD-System erfaßt wird. Wenn die Intensitätsmodulation der Beleuchtung mit der Modulationsfrequenz der Modulationselektroden korreliert, so liefert der Differenzausgang des PMD-Elementes eine Information über die Laufzeit des Lichtes von der Beleuchtungsquelle über die beleuchtete Szene und zurück zu dem PMD-Sensor. Man erhält neben einem Abbild der beleuchteten Szene (wenn eine entsprechende Mehrzahl von PMD-Elementen als Pixelarray geschaltet ist) gleichzeitig eine Information über den Abstand der abgebildeten Elemente der Szene von dem PMD-Element.

Nicht kohärentes Licht (wobei der Begriff "Kohärenz" sich hier immer auf die Frequenz einer Intensitätsmodulation im Verhältnis zu den Modulationsspannungen an den Modulationseingängen der PMD-Elemente bezieht) liefert kein Signal am Differenzausgang der Ausgangselektronik. Mit anderen Worten PMD-Elemente eliminieren (an Ihrem Differenzausgang) automatisch jede nicht kohärent modulierte Hintergrundbeleuchtung.

Dabei sind im übrigen Varianten denkbar, bei welchen Akkumulations- und Modulationselektroden nicht notwendigerweise verschiedene Elemente sind und beispielsweise beide Akkumulationselektroden oder zumindest eine mit beiden bzw. zumindest einer Modulationselektrode identisch ist.

Die oben genannte deutsche Patentschrift DE 100 47 170 beschreibt ein Verfahren, mit welchem zwischen den miteinander in Korrelation stehenden, intensitätsmodulierten Beleuchtungssignalen und den Modulationssignalen eine zusätzliche Phasenverschiebung variabel erzeugt wird, wobei diese Phasenverschiebung als Stellgröße in einem Regelkreis verwendet wird, um auf diese Weise die Genauigkeit der Laufzeit- bzw. Entfernungsbestimmung zu verbessern.

Die vorliegende Erfindung geht von einem PMD-System aus, das im wesentlichen aus ähnlichen oder identischen Elementen aufgebaut ist, wie sie eingangs aufgelistet sind.

Wenn das PMD-Element ausschließlich mit Strahlung beaufschlagt wird, die nicht in kohärenter Beziehung zu dem Modulationssignal steht, so sollte die durch die positiven und negativen Anteile bzw. Halbwellen der Modulationsspannungen abwechselnd vorzugsweise zu der einen und dann zu der anderen Akkumulationselektrode verschobene Ladung sich im statistischen Mittel nicht voneinander unterscheiden, so daß die Differenz der an den Akkumulationselektroden integrierten Spannung im wesentlichen den Wert null zeigen sollte.

Allerdings ergeben sich allein aufgrund unvermeidbarer Herstellungstoleranzen bei konkreten PMD-Elementen mitunter gewisse Asymmetrien zwischen den verschiedenen Akkumulationselektroden und/oder den Modulationselektroden. Auch die geometrischen Maße und Abstände zwischen diesen Elektroden können innerhalb gewisser Toleranzbreiten schwanken.

Die Ausgangssignale eines Photomischdetektors werden innerhalb des Bauelements durch Mischung eines intensitätsmodulierten Ausgangssignals mit einem ebenfalls modulierten elektrischen Signal (Modulationsspannungen) erzeugt. Eine wesentliche Voraussetzung für unverfälschte Ergebnisse des Mischprozesses ist dabei ein hoher Grad an Symmetrie im Aufbau des Photomischdetektors. Unsymmetrien in dessen Geometrie sowie in den elektrischen Parameter der beiden Ausgangskanäle führen zu systematischen Fehlern im Mischergebnis (siehe Dissertation Buxbaum, Seite 189 ff).

Darüber hinaus hängen in der technischen Anwendung von Photomischdetektoren die systematischen Fehler oft auch von der Intensität des Photosignals ab. Insofern sind die von anderen Detektortypen bekannten Korrekturverfahren mit Hilfe von sogenannten look-up-Tabellen sehr aufwendig und wegen der Mehrdimensionalität der Problemstellung für schnelle Vorgänge kaum anwendbar. Dies gilt insbesondere dann, wenn eine Vielzahl von Photomischdetektoren zu einer Zeilen- oder Arrayanordnung verschaltet ist.

Gegenüber diesem Stand der Technik liegt daher der vorliegenden Erfindung die Aufgabe zugrunde, ein System und ein Verfahren zu schaffen, welches auch im Falle von geometrischen oder elektrischen Asymmetrien der PMD-Elemente korrekte Mischergebnisse liefert, d. h. ausschließlich auf der kohärenten Strahlung beruhende Messsignale.

Hinsichtlich des Systems wird diese Aufgabe gemäß Anspruch 1 dadurch gelöst, dass zur Kalibrierung des Systems Einrichtungen zur Veränderung von Parametern des mindestens einen Modulationssignals in der Weise vorgesehen sind, dass durch die Änderung dieser Parameter geometrische oder elektrische Asymmetrien der Elemente des Mischsystems ausgeglichen werden, sodass das Ausgangssignal nur dann von einem Nullsignal verschieden ist, wenn die Modulationen des empfangenen modulierten elektromagnetischen Strahlungssignals und des mindestens einen Modulationssignals miteinander korreliert sind.

Als änderbare Parameter der Modulationsspannungen kommen in diesem Zusammenhang beispielsweise die relative Phasenlage, die Amplituden der Modulationsspannungen, das Tastverhältnis und eine zusätzlich aufgeprägte Offset-Spannung in Frage.

Wie bereits erwähnt, führen Asymmetrien in den geometrischen und/oder elektrischen Parametern der PMD-Elemente zu einer Verfälschung des Meßergebnisses und sie führen insbesondere dazu, daß das Differenzsignal der integrierten PMD-Akkumulationselektroden auch dann nicht verschwindet, wenn keine Beaufschlagung des PMD-Elementes mit einer Modulationsfrequenz der Modulationselektroden kohärenten Strahlung beaufschlagt wird. Wie ebenfalls bereits erwähnt, sollte im Fall eines idealen, symmetrischen PMD-Elementes und für den Fall symmetrischer, genau im Gegentakt an den Modulationselektroden angelegter Modulationsspannungen der Effekt der wechselseitig bevorzugten Ladungsverschiebung sich bei Integration über eine hinreichend lange Zeitdauer aufheben. Dies gilt aber, wie bereits erwähnt, nur bei völliger Symmetrie des PMD-Elementes, und erfordert darüber hinaus selbstverständlich auch eine vollständige Symmetrie der im Gegentakt laufenden Modulationsspannungen.

Mit anderen Worten, wenn das PMD-Element nicht mit intensitätsmodulierter Strahlung beaufschlagt wird, sondern ausschließlich durch Umgebungs- bzw. Hintergrundstrahlung, so kann ein von null verschiedenes Differenzsignal der Ausgänge des PMD-Elementes nicht nur durch geometrische und elektrische Asymmetrien des PMD-Elementes selbst, sondern auch durch eine Asymmetrie der Modulationsspannungen erzeugt werden. Je nach der Art der Asymmetrie kann dabei das von null verschiedene Differenzsignal positive oder negative Werte annehmen.

Wenn daher die Asymmetrie der geometrischen Parameter des PMD-Elementes zu einem von null verschiedenen Differenzsignal am Ausgang des PMD-Elementes führt, so sollte es nach den Erkenntnissen der Erfinder möglich sein, durch eine Asymmetrie der Modulationsspannungen den gegenteiligen Effekt zu erzeugen, also die Asymmetrie der geometrischen Parameter durch eine Asymmetrie der Modulationsspannungen zu korrigieren.

Die erfindungsgemäßen Einsichtungen sind also dazu geeignet und dafür ausgelegt, das (bzw. die) Modulationsignal(e) in der Weise zu verändern, das das Ausgangssignal, welches einer Differenz der aus den Akkumulationselektroden abgeleiteten Signale entspricht, immer den Wert Null hat (abgesehen von leichten Ungenauigkeiten durch nicht vollständig unterdrücktes Rauschen), wenn die Modulationen der empfangenen elektromagnetischen Strahlung und des (der) Modulationssignals (-signale) nicht miteinander korreliert sind. Umgekehrt ausgedrückt könnte man sagen, das das Ausgangssignal dann und nur dann von Null verschieden ist, wenn die betreffenden Modulationen korreliert sind.

Hinsichtlich des Verfahrens wird daher die der Erfindung zugrunde liegende Aufgabe gemäß dem unabhängigen Anspruch 11 dadurch gelöst, dass die Parameter des mindestens einen Modulationssignals zur Kalibrierung des Systems in der Weise verändert werden, dass durch Variation dieser Parameter geometrische oder elektrische Asymmetrien der Elemente des Mischsystems ausgeglichen werden, sodass das Ausgangssignal nur dann einen vom Nullsignal verschiedenen Wert annimmt, wenn das mindestens eine Modulationssignal und das empfangene modulierte elektromagnetische Strahlungssignal miteinander korreliert sind.

Hierzu stehen gemäß der vorliegenden Erfindung verschiedene Möglichkeiten offen. Zum einen kann bei zwei Modulationssignalen die relative Phasenlage der Modulationsspannungen, die bei einem herkömmlichen PMD-Element exakt 180° beträgt, variiert werden, wobei eine Variation der Phasenlage um bis zu ± 30° relativ zueinander im allgemeinen ausreichend sein sollte, und erfindungsgemäß dennoch eine maximale Phasenverschiebung der von 90° der Modulationsspannungen gegeneinander, jeweils ausgehend von einer Gegentakdage, vorgesehen ist.

Eine weitere Möglichkeit, die Modulationsspannungen asymmetrisch zu gestalten, besteht beispielsweise in einer Änderung und Anpassung des Amplitudenverhältnisses. Noch eine weitere Möglichkeit besteht darin, das Tastverhältnis einer der Modulationsspannungen im Verhältnis zu dem Tastverhältnis der anderen Modulationsspannung zu verändern, und schließlich ist es denkbar, zu jeder der Modulationsspannungen noch einen konstanten Offset-Gleichspannungswert zu addieren. Dabei sollte es im allgemeinen ausreichen, wenn das Amplitudenverhältnis und auch das Tastverhältnis der beiden Modulationsspannungen um einen Faktor variiert, der zwischen etwa 0,3 und 3 liegt.

Es versteht sich, daß es ebenso möglich ist, nur eine der Modulationselektroden mit nur einem einzigen Modulationssignal zu beaufschlagen, insbesondere wenn diese mit einer Akkumulationselektrode identisch ist. Durch das Modulationssignal wird das Potential dieser einen Akkumulationselektrode gegenüber einer anderen, benachbarten bzw. räumlich zugeordneten Akkumulationselektrode abwechselnd angehoben oder abgesenkt, so daß im Ergebnis ebenfalls die durch die elektromagnetische Strahlung in dem betreffenden Material erzeugten Ladungen abwechselnd vorzugsweise in Richtung der einen Akkumulationselektrode oder in Richtung der anderen Akkumulationselektrode fließen, je nachdem, ob die modulierte Akkumulationselektrode sich gerade auf einem höheren oder auf einem niedrigeren Potential befindet. In diesem Fall bestehen die erforderlichen Parameteränderungen in einer Änderung der Wellenform oder einer gezielt eingestellten Asymmetrie zwischen positiver und negativer Halbwelle.

Im folgenden wird im wesentlichen die Situation betrachtet, bei welcher beide Akkumulationselektroden entweder direkt oder durch zusätzliche Modulationselektroden mit je einem Modulationssignal beaufschlagt werden, wobei die beiden Modulationssignale im wesentlichen im Gegentakt laufen. Es versteht sich, daß die dabei beschriebene Vorgehensweise völlig analog auch auf ein einzelnes Modulationssignal übertragen werden kann, welches in gleicher Weise durch bestimmte Parameter definiert ist, wie die beiden Modulationssignale bei Verwendung von zwei Modulationselektroden.

Selbstverständlich ist es nicht zwingend, die Parameter der Modulationsspannungen genau in der Weise zu verändern, daß das Differenzsignal des PMD-Elementes genau den Wert null annimmt (solange keine kohärente Bestrahlung erfolgt), es ist jedoch ebenso gut möglich, auch gezielt einen bestimmten Ausgangswert oder Sockelwert des Ausgangssignals bzw. Differenzsignals am Ausgang des PMD-Elementes zu erzeugen.

Zweckmäßigerweise sind die entsprechenden Einrichtungen zur Veränderung der Parameter der Modulationsspannungen so ausgelegt, daß die unterschiedlichen Parameteränderungen voneinander unabhängig sind. Es könnte also ohne weiteres sowohl das Tastverhältnis als auch die Amplitude der einen Modulationsspannung im Verhältnis zu der anderen Modulationsspannung verändert werden. Zusätzlich kann auch die Phasenlage verändert werden oder eine DC-Offset-Spannung aufgeprägt werden. Mit anderen Worten, die Parameter können sowohl einzeln als auch in beliebigen Kombinationen variiert werden. Es versteht sich, daß die vorstehend beschriebenen Parametervariationen in analoger Weise auch mit einem einzelnen Modulationssignal vorgenommen werden können, wobei die entsprechenden Parameter dann keine relativen Parameterverschiebungen zwischen zwei unabhängigen Modulationssignalen sind, sondern statt dessen beispielsweise die positive und negative Halbwelle eines Modulationssignals asymmetrisch ausgebildet wird. Ähnlich wie bei der Verwendung von zwei Modulationssignalen kann auch dann das Tastverhältnis zwischen positiver und negativer Halbwelle variiert werden, ebenso wie die entsprechenden Amplituden der Halbwellen. Beides kann allein durch Aufprägen einer DC-Offsetspannung erfolgen. In Analogie zur Veränderung von Phasen können bei einem einzelnen Modulationssignal ansteigende und abfallende Flanken der Modulationssignale asymmetrisch im Verhältnis zueinander ausgebildet werden.

Vorzugsweise wird das erfindungsgemäße Verfahren mit einer das Ausgangssignal auf Null regelnden Rückkopplung nur dann angewendet, wenn das PMD-Element mit nicht kohärenter Strahlung beaufschlagt wird, wobei sich der Begriff "kohärent" immer auf eine kohärentes Verhältnis der Intensitätsmodulation der Strahlung zu der Frequenz der Modulationsspannungen bezieht. In diesem Zustand sollte, wie bereits erwähnt, bei einem idealen PMD-System das Differenzsignal den Wert Null haben und vorzugsweise werden die Parameter der Modulationsspannungen erforderlichenfalls genau in der Weise verändert, daß der Differenzausgang des PMD-Systems den Wert Null zeigt. Dabei ist es beispielsweise auch möglich, bei Beaufschlagung des PMD-Elementes mit kohärenter Strahlung diese kohärente Strahlung von Zeit zu Zeit für einen kurzen Zeitabschnitt zu unterbrechen, um während dieser Unterbrechung eine Nachjustierung der Parameter der Modulationsspannungen vorzunehmen. Zweckmäßigerweise erfolgt dies mit Hilfe einer Regelschleife, bei welcher das "Leerlaufsignal", welches am Differenzeingang des PMD-Systems ansteht, wenn dieses nicht mit kohärenter Strahlung beaufschlagt wird, als Eingangsgröße in einen Regler eingegeben wird, der daraufhin die Parameter der Modulationsspannungen in der Weise verändert, daß der Leerlaufwert des Differenzausgangs auf Null geregelt wird.

Während der eigentlichen Meßphasen , während welcher das PMD-Element kohärente, intensitätsmodulierte Strahlung empfängt, bleibt die zuvor ermittelte bzw. eingeregelte asymmetrische Einstellung der Parameter der Modulationsspannungen selbstverständlich unverändert erhalten und wird gegebenenfalls erst durch die nächste Kalibrierungsphase wieder geändert.

In einer weiteren, bevorzugten Ausführungsform der Erfindung erfolgt während derartiger Kalibrierphasen vorzugsweise noch eine nicht-kohärente, zusätzliche Strahlungsbeaufschlagung des PMD-Elementes mit einer zusätzlichen Strahlungsintensität, die im Mittel etwa der mittleren Intensität des kohärenten Strahlungsanteils während der Meßphasen entspricht. Auf diese Weise werden intensitätsabhängige Schwankungen des Leerlaufsignals durch die Kalibrierung mit berücksichtigt.

Als Alternative zur Veränderung der Parameter des bzw. der Modulationssignale ist es auch denkbar, die von den Akkumulationselektroden abgeleiteten elektrischen Signale, die im allgemeinen relativ schwache Ströme oder Spannungen sind, welche mit den Eingängen einer Ausgangselektronik verbunden sind, so zu variieren, d.h. zu verstärken oder abzuschwächen, daß sie genau dann gleich sind (und ihre Differenz sich mithin auslöscht), wenn die Modulationen des empfangenen elektromagnetischen Strahlungssignals und des mindestens einen Modulationssignals nicht miteinander korreliert sind. Die vorliegende Erfindung betrifft auch diese Alternative gemäß dem Mischsystem nach Anspruch 17 und dem Verfahren nach Anspruch 18. Dies kann beispielsweise dadurch erfolgen, daß das Mischsystem mit nicht speziell modulierter elektromagnetischer Strahlung, beispielsweise durch Umgebungslicht oder irgendeine beliebige, nicht gezielt modulierte Beleuchtung beaufschlagt wird, während gleichzeitig an dem Modulationseingang bzw. den Modulationseingängen ein bzw. zwei Modulationssignale anliegen (wobei im Falle von zwei Modulationssignalen diese beiden relativ zueinander im Gegentakt laufen), wobei dann die Eingangssignale der Ausgangselektronik miteinander verglichen und mindestens eines der Signale so verstärkt oder abgeschwächt wird, daß es mit dem anderen Eingangssignal identisch ist, so daß die Differenz der beiden von den Akkumulationselektroden abgeleiteten Signale gleich Null wird. Eventuell muß man dies für unterschiedliche Intensitäten der elektromagnetischen Strahlung durchführen, falls die Differenz der beiden Eingangssignale der Ausgangselektronik intensitätsabhängig sein sollte. In diesem Fall würde auch die Variation der Verstärkung bzw. Abschwächung eines der beiden Signale intensitätsabhängig durchgeführt. Bei zusätzlicher Beaufschlagung mit einem modulierten Strahlungssignal erfolgt dann die Abschwächung und Verstärkung des einen Eingangssignals der Ausgangselektronik in der gleichen Weise wie ohne die Beaufschlagung mit der modulierten Spannung, wobei höchstens eine Korrektur wegen der sich dadurch ändernden Gesamtintensität vorgenommen wird. Die Korrelation des Strahlungssignals mit dem Modulationssignal bzw. den Modulationssignalen führt dann dazu, daß die beiden von den Akkumulationselektroden abgeleiteten Eingangssignale der Ausgangselektronik auch nach der Abschwächung oder Verstärkung, wie sie ohne die modulierte Bestrahlung vorgenommen wird, voneinander verschieden sind, so daß die Differenz der beiden Signale nicht verschwindet.

Weitere Vorteile, Merkmale und Anwendungsmöglichkeiten der vorliegenden Erfindung werden deutlich anhand der folgenden Beschreibung einer bevorzugten Ausführungsform und der dazugehörigen Figuren. Es zeigen:
- Figur 1: ein Blockschaltbild mit einer erfindungsgemäßen Kalibriereinheit,
- Figur 2: eine schematische Darstellung der Modulationssignale, mit welchen ein exakt symmetrisches PMD-System beaufschlagt wird,
- Figur 3: eine Variation des Tastverhältnisses eines der Modulationssignale im Verhältnis zu dem anderen Modulationssignal,
- Figur 4: phasenverschobene Modulationssignale,
- Figur 5: Modulationssignale mit unterschiedlichen Amplituden und
- Figur 6: Modulationssignale mit unterschiedlicher Offset-Spannung.

Für die folgende Beschreibung wird als Ausführungsbeispiel ein PMD-Element betrachtet, welches auf elektromagnetische Strahlungen im sichtbaren Bereich empfindlich ist. Dabei werden Ausführungsformen beschrieben, bei welchen das Mischsystem zwei Modulationseingänge und entsprechend zwei Modulationselektroden sowie auch zwei Modulationssignale verwendet, deren Parameter unabhängig voneinander variiert werden können.

Generell sind die Modulationssignale keine rein harmonischen Signale (Sinus oder Cosinus) sondern weisen zweckmäßigerweise eine komplexeren Wellenverlauf auf, um die Modulationssignale und die hierzu korrelierte Modulation der elektromagnetischen Strahlung besser von Umgebungssignalen abtrennen und unterscheiden zu können.

Wie bereits erwähnt, können analog auch die Parameter eines einzelnen Modulationssignals variiert werden, wenn nur ein einzelner Modulationseingang verwendet wird, beispielsweise wenn Akkumulations- und Modulationselektroden bzw. eine der beiden jeweils paarweise vorgesehenen Akkumulationselektroden mit einer Modulationselektrode identisch ist.

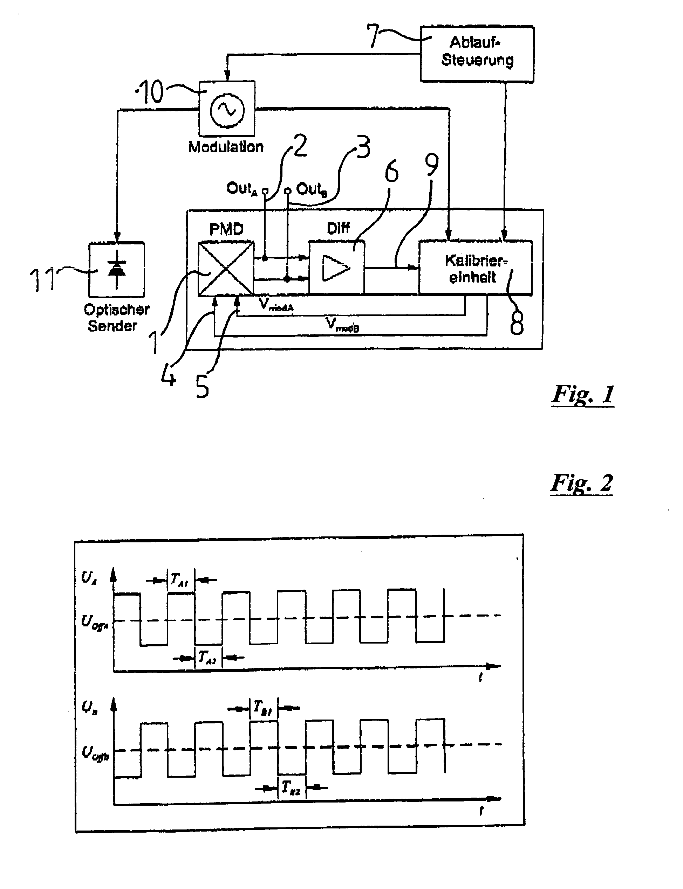

Man erkennt in Figur 1 einen mit 11 bezeichneten optischen Sender, der von einer Modulationseinheit 10 moduliert wird, so daß er Licht mit einer modulierten Intensität abstrahlt. Bei einem herkömmlichen PMD-System werden von der Modulationseinheit 10 gleichzeitig auch die Modulationseingänge 4 und 5 des PMD-Elements 1 moduliert, und zwar in der Weise, daß die Eingangsspannungen U_{A} und U_{B}, die an den Eingängen 4, 5 anliegen, genau im Gegentakt, d.h. relativ zueinander um 180° phasenverschoben sind, wie es in Figur 2 dargestellt ist.

Im vorliegenden Fall ist jedoch erfindungsgemäß eine Kalibriereinheit 8 zwischen die Modulationseinheit 10 und die Modulationseingänge 4, 5 des PMD-Elementes 1 geschaltet. Außerdem werden die Modulationseinheit 10 und die Kalibriereinheit 8 von einer Steuerungselektronik 7 gesteuert, die den Betriebsablauf des gesamten PMD-Systems steuert.

Die an Ausleseelektroden des PMD-Elementes 1 abgegriffenen Spannungen bzw. Ströme erhält man als Signale an den Ausgängen 2, 3, wobei zweckmäßigerweise die Ausgangselektronik 6 in Form eines Differenzverstärkers vorgesehen ist, in die die Ausgangssignale der Ausgänge 2, 3 als Eingangsgrößen eingegeben werden. Das Differenzsignal erscheint am Ausgang 9 der Ausgangselektronik 6 und wird in die Kalibriereinheit 8 eingegeben.

Bei einem idealen, geometrisch und elektrisch symmetrischen PMD-Element sind die Modulationsspannungen U_{A} und U_{B}, wie in Figur 2 dargestellt, mit Ausnahme einer relativen Phasenverschiebung um 180° identisch. Dies bedeutet, daß in dem PMD-Element durch auftreffende Strahlung des optischen Senders bzw. des von einer durch den optischen Sender beleuchteten Szene reflektierten Lichts erzeugte Ladung je nach dem aktuellen Vorzeichen der Spannungen U_{A} und U_{B} bevorzugt auf einen der Ausgänge 2 oder 3 geleitet werden. Die an den Ausgängen 2 und 3 integrierten Signale der auf diese Weise an Akkumulationselektroden erzeugten Ladungen werden durch den Differenzverstärker 6 voneinander subtrahiert, wobei sich im Idealfall an dem Differenzverstärkerausgang 9 ein Nullsignal ergibt (im folgenden auch als "Leerlaufsignal" bezeichnet), wenn das auf das PMD-Element auftreffende Licht in seiner Intensität nicht mit der Frequenz der Modulationsspannungen 4, 5 in Korrelation steht.

Dies gilt insbesondere auch, wenn die Modulation des optischen Senders 11 abgeschaltet ist, so daß nur Umgebungs- bzw. Hintergrundlicht auf das PMD-Element auftrifft.

Wenn jedoch das auf das PMD-Element auftreffende Licht in seiner Intensität mit den Modulationsspannungen U_{AQ} bzw. U_{B} korreliert ist, d.h. insbesondere dieselbe Frequenz hat und lediglich aufgrund einer gewissen Laufzeit phasenverschoben ist, so wird am Ausgang des Differenzverstärkers 6 ein nicht verschwindendes Korrelationssignal erzeugt. In diesem Fall ist die Rückkopplungschleife (Verbindung zum Differenzausgang 9) der Kalibriereinheit abgeschaltet und sendet das Modulationssignal für die Modulationseingänge 4, 5 mit der zuletzt gewählten Parametereinstellung weiter

Wenn allerdings die einzelnen Elektroden des PMD-Elementes 1 geometrisch oder elektrisch nicht vollständig symmetrisch angeordnet und aufgebaut sind, so wird man in der Regel am Ausgang des Differenzverstärkers 6 auch dann ein nicht verschwindendes Signal 9 messen, wenn die Modulation des optischen Senders 11 abgeschaltet ist.

Die erfindungsgemäße Kalibriereinheit sorgt nun aber dafür, daß derartige Asymmetrien, die zu einem nicht verschwindenden Signal am Ausgang 9 des Differenzverstärkers 6 führen, obwohl das PMD-Element mit nicht zur Modulationsfrequenz kohärentem Licht bestrahlt wird, ausgeglichen werden können. Das zeigt schließlich ein Beispiel, in welchem die Spannungen U_{A}, U_{B} um unterschiedliche Offset-Spannungen U_{OFFA} bzw. U_{OFFB} gegenüber einem virtuellen Masseniveau verschoben sind.

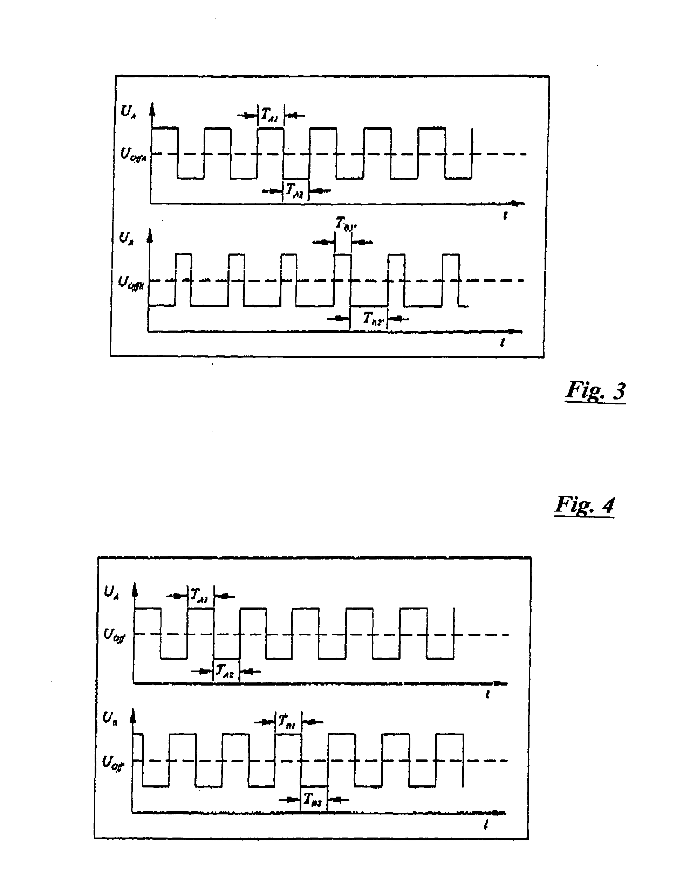

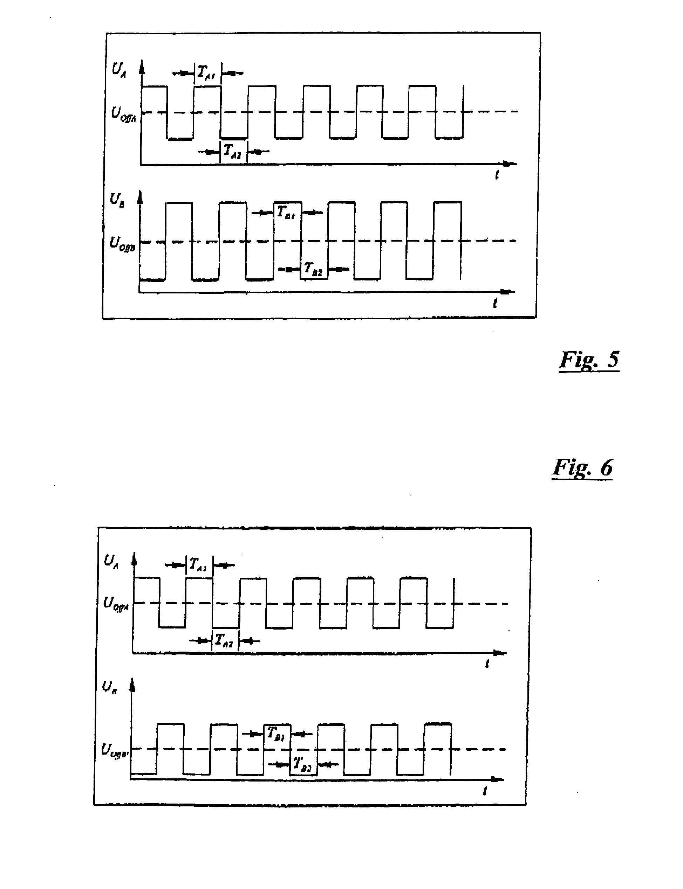

Wenn das PMD-Signal nicht mit moduliertem Licht beaufschlagt wird und das Ausgangssignal 9 am Ausgang des Differenzverstärkers 6 einen nicht verschwindenden Wert hat, so benutzt die Kalibriereinheit mindestens eine der in den Figuren 3 bis 6 dargestellten Variationen der Modulationsspannung, um dadurch die Asymmetrie des PMD-Elementes auszugleichen, daß dennoch am Ausgang 9 des Differenzverstärkers 6 ein Nullsignal erscheint. Hierzu können auch gleichzeitig mehrere der in den Figuren 3 bis 6 dargestellten Variationen vorgenommen werden.

Besonders zweckmäßig ist es, wenn durch die Ablaufsteuerung im laufenden Betrieb eines PMD-Systems die Modulation des optischen Senders 11 während einer laufenden Messung bzw. Aufnahme kurzzeitig abgeschaltet wird, um während dieses Zeitraums die Kalibriereinheit 8 zu aktivieren und das System durch entsprechende Variation der Modulationsspannungen U_{A}, U_{B} an den Eingängen 4 bzw. 5 des PMD-Elementes zu kalibrieren.

Während des Abschaltens der Modulation des optischen Senders 11 könnte allerdings dennoch eine Zusatzbeleuchtung durch den optischen Sender 11 erfolgen, indem dessen Intensität auf einem konstanten, mittleren Niveau gehalten wird, welches auch der mittleren Beleuchtungsintensität im Modulationsbetrieb des optischen Senders entspricht. Auf diese Weise werden insbesondere intensitätsabhängige Gleichgewichtsstörungen des PMD-Systems mit berücksichtigt.

Das erfindungsgemäße Verfahren erlaubt somit eine Kalibrierung von PMD-Systemen in der Weise, daß ein am Ausgang des Differenzverstärkers 6 gemessenes Signal 9 immer exakt dem Korrelationssignal entspricht, so daß hierdurch eine sehr hohe Genauigkeit erzielt werden kann und der Einfluß anderer Strahlungsquellen oder auch der Einfluß von Asymmetrien vollständig vernachlässigt werden kann.

## Patentansprüche

1. Elektromagnetisches Mischsystem für den Empfang und die Verarbeitung modulierter elektromagnetischer Strahlungssignale, mit einem Signaldetektor (1) aus einem Halbleitermaterial für den Empfang und die Umwandlung modulierter elektromagnetischer Strahlungssignale in eine elektrische Meßgröße und mit mindestens einem den Empfang des Signaldetektors modulierenden Modulationseingang, sowie mit mindestens zwei Akkumulationselektroden, die mit einer Ausgangselektronik verbunden sind, an deren Ausgang effektiv eine Mischung des empfangenen, modulierten elektromagnetischen Strahlungssignals und mindestens eines am Modulationseingang anliegenden Modulationssignals (4, 5) als elektrisches Ausgangssignal bereitgestellt wird, **dadurch gekennzeichnet, daß** zur Kalibrierung des Systems Einrichtungen (8) zur Veränderung von Parametern des mindestens einen Modulationssignals in der
Weise vorgesehen sind, daß durch Änderung dieser Parameter geometrische oder elektrische Asymmetrien der Elemente des Mischsystems ausgeglichen werden, sodass das Ausgangssignal nur dann von einem Nullsignal verschieden ist, wenn die Modulationen des empfangenen, modulierten elektromagnetischen Strahlungssignals und des mindestens einen Modulationssignals miteinander korreliert sind.

2. Mischsystem nach Anspruch 1, **dadurch gekennzeichnet, daß** die Einrichtungen (8) dafür ausgelegt sind, die positiven bzw. negativen Halbwellen des mindestens einen Modulationssignals asymmetrisch auszubilden.

3. Mischsystem nach Anspruch 2, **dadurch gekennzeichnet, daß** die Einrichtungen (8) dafür ausgelegt sind, die positiven bzw. negativen Halbwellen des mindestens einen Modulationssignals mit unterschiedlichen Amplituden auszubilden

4. Mischsystem nach Anspruch 2 oder 3, **dadurch gekennzeichnet, daß** die Einrichtungen (8) dafür ausgelegt sind, die positiven bzw. negativen Halbwellen des mindestens einen Modulationssignals mit einem unterschiedlichen Tastverhältnis auszubilden.

5. Mischsystem nach einem der Ansprüche 2 bis 4, **dadurch gekennzeichnet, daß** die Einrichtungen (8) dafür ausgelegt sind einem symmetrischen Modulationssignal einen Gleichspannungswert als Offset zu überlagern.

6. Mischsystem nach einem der Ansprüche 1 bis 5, **dadurch gekennzeichnet, daß** zwei Modulationseingänge für zwei unabhängige Modulationssignale vorgesehen sind, die die gleiche Modulationsfrequenz, jedoch unterschiedlich einstellbare absolute und/oder relative Einstellparameter aufweisen.

7. Mischsystem nach Anspruch 6, **dadurch gekennzeichnet, daß** die einstellbaren Parameter die Amplituden, die Phasenlage, die Tastverhältnisse und etwaige Offsetspannungen der Modulationssignale umfassen.

8. Mischsystem nach einem der Ansprüche 6 oder 7, **dadurch gekennzeichnet, daß** die Einrichtungen (8) dafür ausgelegt sind, die relative Phasenlage der Modulationsspannungen, ausgehend von einer Gegentaktlage, um bis zu maximal ±90° zu verschieben.

9. Mischsystem nach einem der Ansprüche 6 bis 8, **dadurch gekennzeichnet, daß** die Variation des Verhältnisses der Amplitudenmodulationsspannungen bzw. des Tastverhältnisses im wesentlichen auf einen Bereich eines Faktors von etwa 0,3 bis etwa 3 beschränkt ist.

10. Mischsystem nach einem der Ansprüche 1 bis 9, **dadurch gekennzeichnet, daß** die Einrichtungen (8) so ausgelegt sind, daß die Änderungen der verschiedenen Parameter voneinander unabhängig sind.

11. Verfahren zum Betreiben eines elektromagnetischen Mischsystems für den Empfang und die Verarbeitung modulierter elektromagnetischer Strahlungssignale, mit einem Signaldetektor aus einem Halbleitermaterial für den Empfang und die Umwandlung modulierter elektromagnetischer Strahlungssignale in eine elektrische Meßgröße, und mit mindestens einem den Empfang des Signaldetektors modulierenden Modulationseingang sowie mindestens zwei Akkumulationselektroden, die mit einer Ausgangselektronik verbunden sind, an deren Ausgang effektiv eine Mischung des empfangenen, modulierten elektromagnetischen Strahlungssignals und mindestens eines am Modulationseingang anliegenden Modulationssignals als elektrisches Ausgangssignal bereitgestellt wird, wobei durch die auf den Signaldetektor auftreffenden modulierten elektromagnetischen Strahlungssignale Ladungsträger erzeugen, die nach Maßgabe des mindestens einen Modulationssignals zumindest teilweise abwechselnd auf die mindestens zwei verschiedenen Akkumulationselektroden geleitet werden, **dadurch gekennzeichnet, daß** die Parameter des mindestens einen Modulationssignals zur Kalibrierung des Systems in der Weise variiert werden, dass durch Variation dieser Parameter geometrische oder elektrische Asymmetrien der Elemente des Mischsystems ausgeglichen werden, sodass das Ausgangssignal nur dann einen vom Nullsignal verschiedenen Wert annimmt, wenn das mindestens eine Modulationssignal und das empfangene, modulierte elektromagnetische Strahlungssignal miteinander korreliert sind.

12. Verfahren nach Anspruch 11, **dadurch gekennzeichnet, daß** der variierbare Parameter der mindestens einen Modulationsspannungen aus der Gruppe ausgewählt wird, die besteht aus:
a) dem Tastverhältnis der positiven und negativen Halbwellen,
b) der Amplitude der positiven und negativen Halbwellen,
c) einer aufgeprägten DC-Offsetspannung.

13. Verfahren nach einem der Ansprüche 11 oder 12, **dadurch gekennzeichnet, daß** das Ausgangssignal des Mischsystems einer Kalibriereinheit (8) zugeführt wird, welche in einem Kalibrierbetrieb mindestens einen der Parameter mindestens einer Modulationsspannung in der Weise verändert, daß der Wert des Ausgangssignals ein Leerlaufniveau annimmt, wenn das Mischsystem mit einer elektromagnetischen Strahlung bestrahlt wird, deren Intensitätsvariation nicht mit der mindestens einen Modulationsspannung korreliert.

14. Verfahren nach Anspruch 13, **dadurch gekennzeichnet, daß** der Leerlaufwert einem Spannungs- bzw. Stromwert Null des Ausgangssignals entspricht.

15. Verfahren zum Betreiben eines Mischsystems nach einem der Ansprüche 11 bis 14, **dadurch gekennzeichnet, daß** bei Verwenden von mindestens zwei Modulationssignalen die relativen Werte mindestens eines der Parameter der Modulationssignale variiert werden.

16. Verfahren nach Anspruch 15, **dadurch gekennzeichnet, daß** der Parameter einer der Modulationsspannungen, welcher im Verhältnis zu dem entsprechenden Parameter der anderen Modulationsspannung verändert wird, mindestens einer der Parameter ist, die ausgewählt werden aus der Gruppe, welche besteht aus:
a) dem Tastverhältnis,
b) der relativen Phasenlage der beiden Modulationsspannungen,
c) der relativen Amplitude der beiden Modulationsspannungen und
d) einer oder beiden Modulationsspannungen aufgeprägte Offsetspannung.

17. Elektromagnetisches Mischsystem für den Empfang und die, Verarbeitung modulierter elektromagnetischer Strahlungssignale, mit einem Signaldetektor (1) aus einem Halbleitermaterial für den Empfang und die Umwandlung modulierter elektromagnetischer Strahlungssignale in eine elektrische Meßgröße, und mit mindestens einem den Empfang des Signaldetektors modulierenden Modulationseingang, sowie mit mindestens zwei Akkumulationselektroden, die mit einer Ausgangselektronik verbunden sind, an deren Ausgang effektiv eine Mischung des empfangenen, modulierten elektromagnetischen Strahlungssinals und mindestens eines am Modulationseingang anliegenden Modulationssignals (4, 5) als elektromagnetisches Ausgangssignal bereitgestellt wird, **dadurch gekennzeichnet, daß** Einrichtungen (8) zur Kalibrierung der von den Akkumulationselektroden abgeleiteten elektromagnetischen Signale vorgesehen sind, welche diese elektromagnetischen Signale so verstärken oder abschwächen, dass sie gleich groß sind und sich bei Differenzbildung auslöschen, wenn die Modulationen des empfangenen elektromagnetischen Strahlungssignals und des mindestens einen Modulationssignals nicht miteinander korreliert sind, wodurch dann das Ausgangssignal auf ein Nullsignal reduziert wird, sodass geometrische oder elektrische Asymmetrien der Elemente des Mischsystems ausgeglichen werden.

18. Verfahren zum Betreiben eines elektromagnetischen Mischsystems für den Empfang und die Verarbeitung modulierter elektromagnetischer Strahlungssignale, mit einem Signaldetektor aus einem Halbleitermaterial für den Empfang und die Umwandlung modulierter elektromagnetischer Strahlungssignale in eine elektrische Meßgröße, und mit mindestens einem den Empfang des Signaldetektors modulierenden Modulationseingang sowie mindestens zwei Akkumulationselektroden, die mit einer Ausgangselektronik verbunden sind, an deren Ausgang effektiv eine Mischung des empfangenen, modulierten elektromagnetischen Strahlungssignals und mindestens eines am Modulationseingang anliegenden Modulationssignals als elektromagnetisches Ausgangssignal bereitgestellt wird, wobei durch die auf den Signaldetektor auftreffenden modulierten elektromagnetischen Strahlungssignale Ladungsträger erzeugen, die nach Maßgabe des mindestens einen Modulationssignals zumindest teilweise abwechselnd auf die mindestens zwei verschiedenen Ausleseelektroden geleitet werden, **dadurch gekennzeichnet, daß** zur Kalibrierung, um geometrische oder elektrische Asymmetrien der Elemente des Mischsystems auszugleichen, die von den Akkumulationselektroden abgeleiteten Signale so verstärkt oder abgeschwächt werden, daß das Ausgangssignal nur dann einen vom Nullsignal verschiedenen Wert annimmt, wenn das mindestens eine Modulationssignal und das empfangene, modulierte elektromagnetische Strahlungssignal miteinander korreliert sind.

## Claims

1. Electromagnetic mixing system for receiving and processing modulated electromagnetic radiation signals, with a signal detector (1) made from a semiconductor material for receiving and converting modulated electromagnetic radiation signals into an electric measured value and with at least one modulation input modulating the reception of the signal detector, and also with at least two accumulation electrodes which are connected to output electronics at the output of which a mixture of the received modulated electromagnetic radiation signal and at least one modulation signal (4, 5) applied at the modulation input is effectively provided as electric output signal, **characterized in that** apparatuses (8) for modifying parameters of the at least one modulation signal are provided for the calibration of the system in a way that by modifying these parameters, geometric or electric asymmetries of the elements of the mixing system are balanced such that the output signal is different from a zero signal only if the modulations of the received modulated electromagnetic radiation signal and of the at least one modulation signal are correlated with each other.

2. Mixing system according to claim 1, **characterized in that** the apparatuses (8) are designed to develop the positive or negative half-waves of the modulation signal asymmetrically.

3. Mixing system according to claim 2, **characterized in that** the apparatuses (8) are designed to develop the positive or negative half-waves of the modulation signal with different amplitudes.

4. Mixing system according to claim 2 or 3, **characterized in that** the apparatuses (8) are designed to develop the positive or negative half-waves of the modulation signal with a different pulse duty ratio.

5. Mixing system according to one of claims 2-4, **characterized in that** the apparatuses (8) are designed to overlay a symmetrical modulation signal with a DC voltage value as offset.

6. Mixing system according to one of claims 1 to 5, **characterized in that** two modulation inputs are provided for two independent modulation signals which have the same modulation frequency, but differently settable absolute and/or relative setting parameters.

7. Mixing system according to claim 6, **characterized in that** the settable parameters comprise the amplitudes, the phase position, the pulse duty ratios and any offset voltages of the modulation signals.

8. Mixing system according to one of claims 6 or 7, **characterized in that** the apparatuses (8) are designed to displace the relative phase position of the modulation voltages, starting from a push-pull position, by up to a maximum of ±90°.

9. Mixing system according to one of claims 6 to 8, **characterized in that** the variation of the ratio of the amplitude modulation voltages or of the pulse duty ratio is essentially limited to a range of a factor of approximately 0.3 to approximately 3.

10. Mixing system according to one of claims 1 to 9, **characterized in that** the apparatuses (8) are designed such that the modifications of the various parameters are independent of one another.

11. Method for operating an electromagnetic mixing system for receiving and processing modulated electromagnetic radiation signals, with a signal detector made from a semiconductor material for receiving and converting modulated electromagnetic radiation signals into an electric measured value, and with at least one modulation input modulating the reception of the signal detector and also at least two accumulation electrodes which are connected to output electronics at the output of which a mixture of the received modulated electromagnetic radiation signal and at least one modulation signal applied at the modulation input is effectively provided as electric output signal, the modulated electromagnetic radiation signals striking the signal detector producing charge carriers which, depending on the at least one modulation signal, are conducted at least partially alternately to the at least two different accumulation electrodes, **characterized in that** the parameters of at least one modulation signal is varied for the calibration of the system in a way that by varying these parameters, geometric or electric asymmetries of the elements of the mixing system are balanced such that the output signal assumes a value different from zero only if the at least one modulation signal and the received modulated electromagnetic radiation signal are correlated with each other.

12. Method according to claim 11, **characterized in that** the variable parameter of the at least one modulation voltage is selected from the group which consists of:
a) the pulse duty ratio of the positive and negative half-waves,
b) the amplitude of the positive and negative half-waves,
c) an impressed DC offset voltage.

13. Method according to one of claims 11 or 12, **characterized in that** the output signal of the mixing system is fed to a calibration unit (8) which in a calibration operation modifies at least one of the parameters of at least one modulation voltage such that the value of the output signal assumes a no-load level if the mixing system is irradiated by an electromagnetic radiation the intensity variation of which does not correlate with the at least one modulation voltage.

14. Method according to claim 13, **characterized in that** the no-load value corresponds to zero voltage or current value of the output signal.

15. Method for operating a mixing system according to one of claims 11 to 14, **characterized in that**, when using at least two modulation signals, the relative values of at least one of the parameters of the modulation signals are varied.

16. Method according to claim 15, **characterized in that** the parameter of one of the modulation voltages which is modified in relation to the corresponding parameter of the other modulation voltage is at least one of the parameters which are selected from the group which consists of:
a) the pulse duty ratio,
b) the relative phase position of the two modulation voltages,
c) the relative amplitude of the two modulation voltages and
d) offset voltage impressed on one or both modulation voltages.

17. Electromagnetic mixing system for receiving and processing modulated electromagnetic radiation signals, with a signal detector (1) made from a semiconductor material for receiving and converting modulated electromagnetic radiation signals into an electric measured value and with at least one modulation input modulating the reception of the signal detector, and also with at least two accumulation electrodes which are connected to output electronics at the output of which a mixture of the received, modulated electromagnetic radiation signal and at least one modulation signal (4, 5) applied at the modulation input is effectively provided as electromagnetic output signal, **characterized in that** apparatuses (8) for calibrating the electromagnetic signals derived from the accumulation electrodes are provided which amplify or attenuate these electromagnetic signals such that they are of the same magnitude and delete themselves in case of differentiation when the modulations of the received electromagnetic radiation signal and the at least one modulation signal are not correlated with each other, the output signal being reduced to a zero signal such that geometric and electric asymmetries of the elements of the mixing system are balanced.

18. Method for operating an electromagnetic mixing system for receiving and processing modulated electromagnetic radiation signals, with a signal detector made from a semiconductor material for receiving and converting modulated electromagnetic radiation signals into an electric measured value, and with at least one modulation input modulating the reception of the signal detector and also at least two accumulation electrodes which are connected to output electronics at the output of which a mixture of the received modulated electromagnetic radiation signal and at least one modulation signal applied at the modulation input is effectively provided as electric output signal, the modulated electromagnetic radiation signals striking the signal detector producing charge carriers which, depending on the at least one modulation signal, are conducted at least partially alternately to the at least two different readout electrodes, **characterized in that** for the calibration, in order to balance geometric or electronic asymmetries of the elements of the mixing system, the signals derived from the accumulation electrodes are amplified or attenuated such that the output signal assumes a value different from zero only if the at least one modulation signal and the received modulated electromagnetic radiation signal are correlated with each other.

## Revendications

1. Système mélangeur électromagnétique pour la réception et le traitement de signaux de rayonnement électromagnétique modulés, ledit système comportant un détecteur de signal (1) en matériau semi-conducteur pour la réception et la conversion de signaux de rayonnement électromagnétique modulés en grandeur de mesure électrique et au moins une entrée de modulation modulant la réception du détecteur de signal, ainsi que au moins deux électrodes d'accumulation qui sont reliées à une électronique de sortie à la sortie de laquelle un mélange du signal de rayonnement électromagnétique modulé reçu et au moins un signal de modulation (4, 5) à l'entrée de modulation est délivré en tant que signal de sortie électrique, **caractérisé en ce que** pour étalonner le système il est prévu des dispositifs (8) destinés à faire varier des paramètres de l'au moins un signal de modulation de façon à ce que, en faisant varier ces paramètres, on compense des asymétries géométriques ou électriques des éléments du système mélangeur de sorte que le signal de sortie n'est différent d'un signal nul que si les modulations du signal de rayonnement électromagnétique modulé reçu et de l'au moins un signal de modulation sont corrélés entre elles.

2. Système mélangeur selon la revendication 1, **caractérisé en ce que** les dispositifs (8) sont conçus pour conformer de façon asymétrique les demi-ondes positives ou négatives de l'au moins un signal de modulation.

3. Système mélangeur selon la revendication 2, **caractérisé en ce que** les dispositifs (8) sont conçus pour conformer les demi-ondes positives ou négatives de l'au moins un signal de modulation avec des amplitudes différentes.

4. Système mélangeur selon la revendication 2 ou 3, **caractérisé en ce que** les dispositifs (8) sont conçus pour conformer les demi-ondes positives ou négatives de l'au moins un signal de modulation avec un taux d'impulsions différent.

5. Système mélangeur selon l'une des revendications 2 à 4, **caractérisé en ce que** les dispositifs (8) sont conçus pour superposer en tant qu'offset une valeur de tension continue à un signal de modulation symétrique.

6. Système mélangeur selon l'une des revendications 1 à 5, **caractérisé en ce que** deux entrées de modulation sont prévues pour deux signaux de modulation indépendants qui ont la même fréquence fondamentale mais qui ont des paramètres de réglage absolus et/ou relatifs réglables de façons différentes.

7. Système mélangeur selon la revendication 6, **caractérisé en ce que** les paramètres réglables comportent les amplitudes, la position de phase, les taux d'impulsions et d'éventuelles tensions d'offset des signaux de modulation.

8. Système mélangeur selon l'une des revendications 6 ou 7, **caractérisé en ce que** les dispositifs (8) sont conçus pour décaler de ±90° maximum la position de phase relative des tensions de modulation, en partant d'une position symétrique.

9. Système mélangeur selon l'une des revendications 6 à 8, **caractérisé en ce que** la variation du rapport des tensions de modulation d'amplitude ou du rapport d'impulsions est limitée sensiblement à une plage de facteur allant de 0,3 environ à 3 environ.

10. Système mélangeur selon l'une des revendications 1 à 9, **caractérisé en ce que** les dispositifs (8) sont conçus de telle sorte que les variations des différents paramètres sont indépendantes l'une de l'autre.

11. Procédé d'exploitation d'un système mélangeur électromagnétique pour la réception et le traitement de signaux de rayonnement électromagnétique modulés, avec un détecteur de signal en matériau semi-conducteur pour la réception et la conversion de signaux de rayonnement électromagnétique modulés en grandeur de mesure électrique et avec au moins une entrée de modulation modulant la réception du détecteur de signal, ainsi que au moins deux électrodes d'accumulation qui sont reliées à une électronique de sortie à la sortie de laquelle un mélange du signal de rayonnement électromagnétique modulé reçu et au moins d'un signal de modulation à l'entrée de modulation est réellement délivré en tant que signal de sortie électrique, procédé dans lequel des signaux de rayonnement électromagnétique modulés apparaissant sur le détecteur de signal génèrent des porteurs de charges qui sont acheminés de façon au moins partiellement alternative sur les au moins deux électrodes d'accumulation différentes conformément à l'au moins un signal de rayonnement, **caractérisé en ce que** l'on fait varier les paramètres de l'au moins un signal de modulation pour étalonner le système de sorte que, en faisant varier ces paramètres, on compense des asymétries géométriques ou électriques des éléments du système mélangeur de sorte que le signal de sortie ne prend une valeur différente du signal nul que si l'au moins un signal de modulation et le signal de rayonnement électromagnétique modulé reçu sont corrélés entre eux.

12. Procédé selon la revendication 11, **caractérisé en ce que** le paramètre variable de l'au moins une tension de modulation est choisi dans le groupe qui est constitué :
a) du taux d'impulsions des demi-ondes positives et négatives,
b) de l'amplitude des demi-ondes positives et négatives,
c) de la tension offset continue appliquée.

13. Procédé selon l'une des revendications 11 ou 12, **caractérisé en ce que** le signal de sortie du système mélangeur est amené à une unité d'étalonnage (8) qui fait varier dans un mode d'étalonnage au moins un des paramètres d'au moins une tension de modulation de façon à ce que la valeur du signal de sortie prend un niveau en circuit ouvert lorsque le système mélangeur est irradié avec un rayonnement électromagnétique dont la variation d'intensité n'est pas corrélée avec l'au moins une tension de modulation.

14. Procédé selon la revendication 13, **caractérisé en ce que** la valeur en circuit ouvert correspond à une valeur de tension ou de courant nulle du signal de sortie.

15. Procédé d'exploitation d'un système mélangeur selon l'une des revendications 11 à 14, **caractérisé en ce que**, lorsque l'on utilise au moins deux signaux de modulation, on fait varier les valeurs relatives d'au moins un des paramètres des signaux de modulation.

16. Procédé selon la revendication 15, **caractérisé en ce que** le paramètre de l'une des tensions de modulation que l'on fait varier par rapport au paramètre correspondant de l'autre tension de modulation, est au moins un des paramètres qui sont choisis dans le groupe qui est constitué :
a) du taux d'impulsions
b) de la position de phase relative des deux tensions de modulation,
c) de l'amplitude relative des deux tensions de modulation et
d) de l'une ou des deux tensions de modulation dotées d'une tension offset.

17. Système mélangeur électromagnétique pour la réception et le traitement de signaux de rayonnement électromagnétique modulés, ledit système comportant un détecteur de signal (1) en matériau semi-conducteur pour la réception et la conversion de signaux de rayonnement électromagnétique modulés en grandeur de mesure électriques et au moins une entrée de modulation modulant la réception du détecteur de signal, ainsi que au moins deux électrodes d'accumulation qui sont reliées à une électronique de sortie à la sortie de laquelle un mélange du signal de rayonnement électromagnétique modulé reçu et d'au moins un signal de modulation (4, 5) à l'entrée de modulation est réellement délivré en tant que signal de sortie électromagnétique, **caractérisé en ce que** des dispositifs (8) sont prévus pour étalonner les signaux électromagnétiques pris sur les électrodes d'accumulation, lesquels amplifient et atténuent ces signaux électromagnétiques de façon à ce qu'ils soient de même grandeur et qu'ils soient supprimés en cas de soustraction si les modulations du signal de rayonnement électromagnétique reçu et de l'au moins un signal de modulation ne sont pas corrélées entre elles, de sorte que le signal de sortie est alors réduit à un signal nul de façon à compenser des asymétries géométriques ou électriques des éléments du système mélangeur.

18. Procédé d'exploitation d'un système mélangeur électromagnétique pour la réception et le traitement de signaux de rayonnement électromagnétique modulés, ledit système comportant un détecteur de signal en matériau semi-conducteur pour la réception et la conversion de signaux de rayonnement électromagnétiques modulés en grandeur de mesure électrique et au moins une entrée de modulation modulant la réception du détecteur de signal, ainsi que au moins deux électrodes d'accumulation qui sont reliées à une électronique de sortie à la sortie de laquelle un mélange du signal de rayonnement électromagnétique modulé reçu et d'au moins un signal de modulation à l'entrée de modulation est réellement délivré en tant que signal de sortie électromagnétique, procédé dans lequel des signaux de rayonnement électromagnétiques modulés apparaissant sur le détecteur de signal génèrent des porteurs de charges qui sont amenés de façon au moins partiellement alternative sur les au moins deux électrodes de sélection différentes, **caractérisé en ce que**, pour effectuer l'étalonnage afin de compenser des asymétries géométriques ou électriques des éléments du système mélangeur, les signaux pris sur les électrodes d'accumulation sont amplifiés ou atténués de sorte que le signal de sortie ne prend une valeur différente du signal nul que si l'au moins un signal de modulation et le signal de rayonnement électromagnétique modulé reçu sont corrélés entre eux.
